**Europäisches Patentamt**

**European Patent Office**

**Office européen des brevets**

(19)

(11) Numéro de publication: **0 205 359 B1**

(12)

# FASCICULE DE BREVET EUROPEEN

(45) Date de publication du fascicule du brevet:
**13.12.89**

(51) Int. Cl.⁴: **G02B 6/42**

(21) Numéro de dépôt: **86400908.9**

(22) Date de dépôt: **24.04.86**

(54) **Composant optoélectronique bidirectionnel formant coupleur optique.**

(30) Priorité: **10.05.85 FR 8507147**

(43) Date de publication de la demande:
**17.12.86 Bulletin 86/51**

(45) Mention de la délivrance du brevet:
**13.12.89 Bulletin 89/50**

(84) Etats contractants désignés:
**DE GB IT NL SE**

(56) Documents cités:
**FR-A- 2 536 546**
**FR-A- 2 541 466**
**US-A- 4 423 922**

**PATENTS ABSTRACTS OF JAPAN,**
**vol. 8, no. 51 (P-259)[1488], 8 mars 1984; & JP - A**
**- 58 202 423 (FUJITSU K.K.) 25-11-1983**
**PATENTS ABSTRACTS OF JAPAN,**
**vol. 8, no. 29 (E-226)[1466], 7 février 1984, page 38 E 226;**
**& JP - A - 58 190 076 (FUJITSU K.K.) 05-11-1983**

(73) Titulaire: **THOMSON-CSF, 51, Esplanade du Général de Gaulle, F-92800 Puteaux(FR)**

(72) Inventeur: **Simon, Jacques, c/o Thomson-CSF SCPI 19, avenue de Messine, F-75008 Paris(FR)**
Inventeur: **Morel, Philippe, c/o Thomson-CSF SCPI 19, avenue de Messine, F-75008 Paris(FR)**
Inventeur: **Carpentier, Jean-François, c/o Thomson-CSF SCPI 19, avenue de Messine, F-75008 Paris(FR)**

(74) Mandataire: **Taboureau, James et al, THOMSON-CSF SCPI, F-92045 PARIS LA DEFENSE CEDEX 67(FR)**

ACTORUM AG

## Description

La présente invention concerne un composant optoélectronique, utilisé dans les systèmes de transmission de données par fibres optiques. Ce composant optoélectronique est un coupleur qui comprend au moins une diode électroluminescente et une photodiode : l'ensemble de ces deux diodes est intégré dans un boitier d'encapsulation normalisé pour les transistors. L'invention s'applique plus particulièrement aux liaisons bidirectionnelles sur une seule fibre optique dite monofibre.

Dans une liaison optique bidirectionnelle monofibre, l'unique fibre optique transmet, dans un sens qu'on appellera l'aller, la lumière émise par une diode électroluminescente, dite DEL, placée à une première extrémité de la fibre, et reçue par une photodiode placée à une seconde extrémité de la fibre. Dans l'autre sens, qu'on appellera alors le retour, la lumière émise par une seconde DEL, placée à la seconde extrémité de la fibre, est reçue par une seconde photodiode, placée à la première extrémité de la fibre. Il y a donc, à chaque extrémité de la fibre optique, une DEL et une photodiode, qui doivent toutes deux être en liaison optique avec l'extrémité qui leur est voisine de la fibre optique. Les solutions connues pour assurer ce couplage optique sont en général assez volumineuses : les coupleurs sont constitués par un boitier dont les faces supportent des connecteurs optiques. Il y a au moins un connecteur pour la fibre optique, un connecteur pour la DEL dans son microboitier et un connecteur pour la photodiode dans son microboitier. A l'intérieur du boitier du coupleur, des moyens simples couplent la DEL à la fibre optique et la photodiode à la fibre optique. Le principal inconvénient de ces coupleurs, par ailleurs simples, est leur encombrement ; en outre en raison des très petites dimensions des fibres optiques utilisées dans les systèmes bidirectionnels (50-100um), ces coupleurs requièrent une grande précision d'usinage à chaque liaison par connecteurs.

Le composant optoélectronique selon l'invention est d'un volume beaucoup plus réduit que les coupleurs connus, et il peut facilement être aligné sur l'axe optique de la fibre optique. Il comporte au moins une DEL et une photodiode, et au moins un miroir semitransparent, l'ensemble étant intégré dans un boitier standard d'encapsulation de transistor, munie d'une microlentille sur la face plane de son couvercle. La DEL et la photodiode sont montées côte à côte, sur une embase isolante, la DEL étant dans l'axe optique de la microlentille, et elle-même munie d'une microbille optique, afin de concentrer son rayonnement lumineux sur la microlentille. La photodiode reçoit le rayonnement lumineux entrant dans le boitier, ou une partie du rayonnement lumineux émis par la DEL, au moyen d'un lieu de miroirs positionnés à l'intérieur du couvercle du boitier: il y a au moins un miroir semitransparent qui est maintenu en position par une pièce dont une face usinée en regard de la photodiode prend la fonction de miroir.

De façon plus précise l'invention concerne un composant optoélectronique bidirectionnel, comportant une diode électroluminescente d'émission et au moins une photodiode de détection, la diode électroluminescente, dite DEL, étant montée à l'intérieur d'un boitier métallique de type boitier de transistor, dont l'embase supporte un pavé isolant sur lequel est fixée la DEL et dont le couvercle supporte une microlentille, centrée sur la face plane du couvercle, la microlentille et la DEL définissant un axe optique pour ce composant optoélectronique, caractérisé en ce que sont intégrés à l'intérieur du boitier de la DEL:

– au moins une photodiode de détection, montée sur le pavé isolant à côté de la DEL et en dehors de l'axe optique du composant,
– un premier moyen de réflexion du rayonnement lumineux détecté, constitué par un miroir semi-transparent, supporté entre la DEL et la microlentille, sur l'axe optique du composant et incliné par rapport à celui-ci,
– un second moyen de réflexion du rayonnement lumineux en direction de la photodiode de détection, constitué par une surface réfléchissante, dont le plan est parallèle au plan du miroir semi-transparent, la pièce dans laquelle est réalisée la surface réfléchissante comportant également une surface plane support du miroir semi-transparent.

Dans une première variante de l'invention la photo diode de détection est utilisée non pas pour recevoir un rayonnement lumineux provenant de l'extérieur du composant optoélectronique, mais pour contrôler et réguler la lumière émise par la diode électroluminescente, ce qui entraine une modification des moyens de réflexion.

Dans une deuxième variante de l'invention, deux diodes de réception détectent l'une un rayonnement extérieur, l'autre le rayonnement émis par la diode électroluminescente.

L'invention sera mieux comprise, et ses avantages ressortiront de la description suivante de quelques exemples de réalisation, cette description s'appuyant sur les figures jointes en annexe qui représentent:

– figure 1: schéma de principe d'une liaison bidirectionnelle par fibre optique, selon l'art connu,
– figure 2: schéma d'un coupleur optique selon l'art connu,
– figure 3: schéma d'un autre coupleur optique selon l'art connu,
– figure 4: vue en coupe d'un composant optoélectronique selon l'invention, simplifié, comportant une DEL d'émission et une photodiode de réception,
– figure 5: schéma de principe d'une liaison simple par fibre optique selon l'art connu, comportant une régulation d'émission de chaque DEL, aux extrémités de la fibre optique,
– figure 6: vue en coupe d'un composant optoélectronique selon l'invention, simplifié, comportant une DEL d'émission et une photodiode de régulation de la puissance lumineuse émise,
– figure 7: vue en coupe d'un composant optoélectronique selon l'invention, simplifié, selon une variante dans le système optique, de régulation de la puissance lumineuse émise,

– figure 8: vue en coupe d'un composant optoélectronique selon l'invention, pour l'émission et la réception, montrant le système optique support de miroir,

– figure 9: vue en coupe du composant optoélectronique selon l'invention, pour l'émission, la régulation de puissance et la réception, montrant le système optique support de miroir,

– figures 10 à 12 : trois systèmes de fixation du support de miroir à l'intérieur du couvercle du boitier.

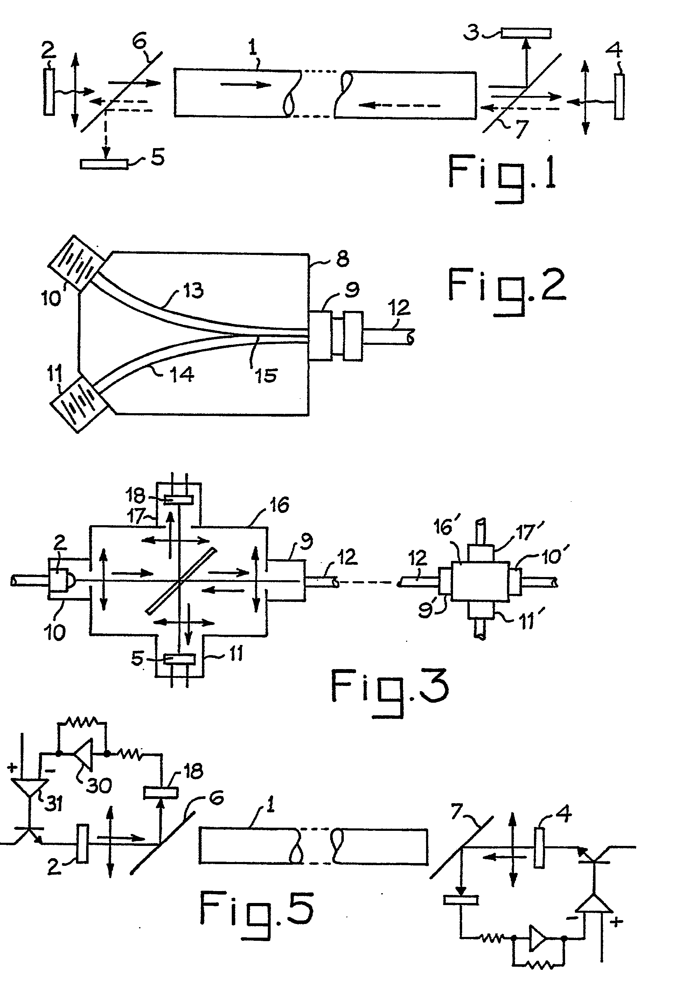

La figure 1 représente le schéma de principe d'une liaison bidirectionnelle par fibre optique, selon l'art connu et son exposé permettra de mieux comprendre l'intérêt du composant optoélectronique selon l'invention.

Une liaison bidirectionnelle par fibre optique comprend une fibre optique 1, à une première extrémité de laquelle se trouve une diode électroluminescente DEL, schématisée en 2 par la représentation de sa pastille semiconductrice. Cette DEL émet un rayonnement lumineux, concentré par une microlentille et qui se propage le long de la fibre optique selon les flèches représentées en trait continu. A l'autre extrémité de la fibre optique 1 se trouve une photodiode détectrice 3, qui capte la lumière émise par la DEL. Le fait que cette liaison soit bidirectionnelle sous-entend qu'à cette même seconde extrémité de la fibre optique 1 se trouve également une seconde DEL 4 dont le rayonnement lumineux, concentré par une microlentille, traverse la même fibre optique 1, selon un parcourt schématisé par des flèches en traits discontinus : le rayonnement lumineux de la DEL 4 est recueilli à la première extrémité de la fibre optique par une photodiode 5. Puisqu'à chaque extrémité de la fibre optique 1 se trouvent à la fois une DEL émettrice 2 ou 4 et une photodiode détectrice 3 ou 5, il est nécessaire de dévier partiellement les rayons lumineux de façon à ce que les deux DEL 2 et 4 et les deux photodiodes 3 et 5 soient, respectivement, couplées à la fibre optique. Les moyens de déviation des rayons lumineux sont schématisés par des miroirs 6 et 7, placés chacun à une extrémité de la fibre optique : ces miroirs sont semitransparents ce qui sous entend qu'une partie du rayonnement émis par la DEL 2 traverse le miroir 7 et vient frapper la DEL 4, et que réciproquement une partie du rayonnement émis par la DEL 4 traverse le miroir 6 et vient frapper la DEL 2, cependant que les rayonnements correspondants sont réfléchis par les surfaces des miroirs semitransparents 6 et 7, et viennent frapper les photodiodes 3 et 5.

Ce schéma de la figure 1 est, comme il a été précisé, un schéma de principe, parce qu'en fait les coupleurs entre DEL et photodiode sont réalisés de façon différente.

La figure 2 représente le schéma très simplifié d'un coupleur optique selon l'art connu. Ce premier type de coupleur comporte un boitier 8, dont la forme est quelconque pourvu que puissent y être fixés trois connecteurs 9, 10 et 11, au sommet d'un triangle. Une fibre optique 12, qui correspond à la fibre 1 de la figure 1, est connectée à ce coupleur au moyen d'un connecteur 9. Une DEL est connectée à ce coupleur au moyen d'un connecteur 10 dont seule l'embase est représentée, la DEL étant elle-même montée dans un microboitier. Une photodiode est connectée au coupleur au moyen d'une seconde embase 11, qui pour les mêmes raisons est représentée uniquement par son embase filetée. Le couplage du rayonnement lumineux entre la fibre optique 12 d'une part, la DEL et la photodiode d'autre part, se fait au moyen de deux fibres optiques 13 et 14, situées à l'intérieur du boitier 8 du coupleur qui les protège.

Ces deux fibres optiques 13 et 14 sont usinées en 15, de façon à leur donner à chacune un méplat, et les deux fibres sont positionnées méplat contre méplat dans le connecteur 9 de la fibre optique 12. Les deux fibres 13 et 14 sont par ailleurs connectées dans les embases des connecteurs 10 et 11. Il est évident que ce type de coupleur qui met en oeuvre au moins trois connecteurs et un boitier avec deux morceaux de fibres optiques occupe un certain volume, qui n'est pas du même ordre de grandeur que le volume occupé par une DEL, ou par une photodiode, ou qui soit à l'échelle du diamètre de la fibre optique qui est de 50 à 100 microns.

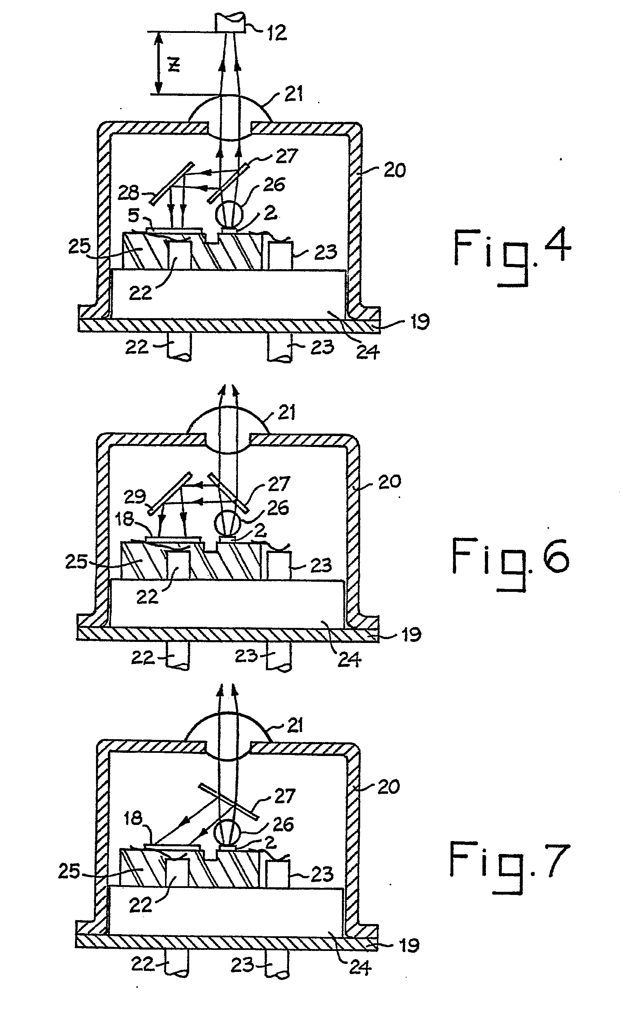

La figure 3 représente un autre type de coupleur selon l'art connu. Celui-ci se présente sous la forme d'un boitier 16, qui comporte sur quatre faces, disposées de préférence selon un carré ou un rectangle, quatre connecteurs 9, 10, 11 et 17. Dans le premier connecteur 9 est fixée, comme en figure 2, une extrémité de la fibre optique 12. Le second connecteur 10 supporte la diode électroluminescente 2 qui émet un rayonnement lumineux en direction de la fibre optique 12 : par conséquent le connecteur 10 est situé dans l'axe optique de la fibre 12, et sur une paroi du boitier 16 parallèle à la paroi qui supporte le connecteur 9. Le connecteur 11 supporte la photodiode 5 et est situé sur une paroi parallèle à l'axe optique de la fibre 12 : le renvoi du rayonnement lumineux vers la photodiode 5 se fait au moyen d'un miroir semitransparent 6, positionné à 45° par rapport au trajet du rayonnement lumineux entre la photodiode 2 et la fibre optique 12. Accessoirement une seconde photodiode 18, supportée par un connecteur 17 peut être montée en vis-à-vis de la première photodiode 5. Cette seconde photodiode 18 reçoit, au moyen du même miroir semitransparent 6, une partie de la lumière émise par la DEL 2 et sert ainsi à réguler la puissance d'émission de la DEL. Des lentilles sont généralement utilisées afin d'assurer un meilleur couplage et obtenir des faisceaux parallèles au niveau du miroir.

A l'autre extrémité de la fibre optique 12 se trouve un boitier 16', qui est tout à fait comparable au boitier 16 : il comporte lui aussi des connecteurs pour pouvoir coupler ensemble la fibre optique 12, une seconde DEL et une ou deux photodiodes.

Dans les deux cas de coupleurs selon l'art connu qui viennent d'être brièvement présentés, le volume occupé est un élément important. En effet, les liaisons optiques bidirectionnelles sont utilisées si la perte de puissance optique engendrée dans les coupleurs peut être compensée par une puissance d'émission plus grande des diodes électroluminescentes. Ce désavantage est compensé par le fait que dans des systèmes extrêmement complexes, tels que les centraux téléphoniques par exemple, une seule fibre optique permet la communication de données dans les deux sens et il y a donc un gain considérable d'encombrement dans le cas de cables multifibres à forte densité. Ce gain d'encombrement au niveau du cable multifibre serait perdu si à l'extrémité de chaque fibre optique le coupleur est un objet lui-même encombrant.

En outre l'usinage de fibre optique d'un diamètre même de 100 microns n'est pas une chose aisée, et le réglage et l'alignement d'une fibre optique dans son connecteur par rapport à deux ou à trois diodes montées sur leurs connecteurs 10 ou 11 ou 17 nécessite de grandes précautions : par conséquent ces coupleurs présentent des inconvénients qui font qu'ils ne sont pas très applicables dans l'industrie.

C'est donc un objet de l'invention que de mettre au point un système de couplage qui est pré-réglé en fabrication, et qui n'occupe qu'un faible volume, compatible avec le niveau de diamètre d'une fibre optique. Le volume dans lequel est réalisé le composant optoélectronique selon l'invention est celui d'un boitier métallique normalisé de transistor, de type TO18 ou TO46, c'est-à-dire de diamètre extérieur égal à 5,4 mm.

La figure 4 représente une vue en coupe d'un composant optoélectronique selon l'invention, cette vue étant simplifiée de façon à en faciliter la lecture. Ce composant optoélectronique comporte une diode électroluminescente d'émission et une photodiode de réception.

Le composant optoélectronique de la figure 4 est monté dans un boitier normalisé de transistor, de type TO18. Ce boitier comporte une embase 19 et un couvercle 20, l'embase 19 comportant elle-même au moins une couronne métallique de façon à pouvoir être soudée sur le couvercle 20.

Dans le couvercle 20 est réalisée, sur la partie plane de ce couvercle et sur l'axe de symétrie du boitier, une microlentille 21, généralement en verre, qui définit un axe optique pour le boitier.

L'embase 19 supporte une pluralité de connexions d'accès extérieur 22 et 23, mais il y en a au moins deux, une pour chaque diode. Ces connexions d'accès extérieur 22 et 23 qui se présentent sous forme de fils métalliques, sont maintenues en place par une partie 24 qui est soit en verre, soit en métal, solidaire de l'embase 19 : dans ce cas les passages des connexions externes 22 et 23 sont isolés par des perles de verre.

Si le boitier ne comporte que deux connexions extérieures 22 et 23 pour deux pastilles de diodes, la connexion de masse peut être prise directement sur le boitier.

La pastille 2 de diode électroluminescente et la pastille 5 de photodiode sont montées, par les moyens appropriés de soudure ou de collage, côte à côte sur une embase isolante 25, qui est par exemple en oxyde de Beryllium. Ces deux pastilles sont montées de telle façon que la pastille 2 de diode électroluminescente se trouve dans l'axe optique de la microlentille 21 portée par le couvercle de boitier et dans l'alignement de la fibre optique 12.

Une microbille, qui est réalisée soit en verre, soit en corindon, soit en matière plastique, soit avec le matériau semi-conducteur constituant la puce de DEL elle-même, est collée sur la surface émissive de la pastille 2 de diode électroluminescente : cette microbille 26 fait office de microlentille pour concentrer le rayonnement lumineux émis par la diode électroluminescente -laquelle émet selon un angle assez important- en direction de la microlentille 21, de façon à récupérer le maximum d'énergie lumineuse de la DEL et améliorer le rendement.

Du fait que la pastille 2 de la DEL est située sur l'axe optique du système, la pastille 5 de la photodiode est donc située en dehors de cet axe. Pour que le rayonnement lumineux émis par l'autre DEL, située à l'autre extrémité de la fibre optique 12, parvienne à la photodiode 5, deux miroirs 27 et 28 sont disposés à l'intérieur du boitier de ce composant optoélectronique. Le miroir 27 est un miroir semitransparent, constitué par une lame de verre ou de quartz fine intercalée entre la bille 26 et la microlentille 21. Selon les lois bien connues de l'optique ce miroir est incliné à 45° par rapport à l'axe optique. Un second miroir 28, lui aussi incliné à 45° par rapport à l'axe optique, fait face au premier miroir 27 de telle façon qu'un rayonnement lumineux sortant de la fibre optique 12 se réfléchit une première fois sur le miroir semitransparent 27 puis une seconde fois sur le miroir 28 avant de frapper la pastille de la photodiode 5.

La façon dont sont positionnés à l'intérieur du boitier les miroirs 27 et 28 sera détaillée ultérieurement. Bien entendu, et bien que cela n'ait pas était décrit, les pastilles sont soudées sur l'embase 25 par des procédés connus, et elles sont connectées avec les connexions extérieures 22 et 23 par tous moyens fiables connus de l'homme de l'art, tels par exemple des fils métalliques ou des rubans métalliques.

Pour une fibre optique de diamètre 50 ou 100 microns, le diamètre de la microbille 26 peut être compris entre 200 et 700 microns. La distance entre la microbille 26 et la microlentille 21 est d'environ 1,5 mm, et elle permet de placer un miroir 27 d'épaisseur environ 0,1 mm. La distance focale de la microlentille 21 est de l'ordre du millimètre, et la distance frontale Z, qui sépare la microlentille 21 de l'extrémité de la fibre optique 12, est comprise entre 0,5 et 1,5 mm.

Le fonctionnement de ce composant optoélectronique est le même que celui qui est exposé en figure 1. La DEL 2 émet un rayonnement lumineux qui est d'abord recueilli et concentré par la microbille 26, traverse -avec une certaine perte par réflexion- le miroir semitransparent 27 avant d'être focalisé par la microlentille 21 sur le coeur de la fibre 12. La photodiode reçoit le signal optique issu de la fibre par l'intermédiaire de la microlentille 21, du miroir semitransparent 27 et de la surface réfléchissante 28.

Ce qui caractérise l'originalité de ce composant optoélectronique est qu'il suffit d'ajouter trois éléments dans un composant classique d'émission pour le transformer en un composant ayant une fonction émission et une fonction réception, c'est-à-dire en un coupleur. Une DEL 2, munie de sa microbille 26,

montée dans un boîtier métallique 19+20 munie lui-même d'une microlentille 21 est un composant connu. Il a suffi d'ajouter un miroir semitransparent 27, un support de miroir qui, comme on le verra plus loin, constitue lui-même une seconde surface réfléchissante 28, et une photodiode 5 pour transformer ce composant d'émission connu en un composant d'émission-réception nouveau. On remarquera que la lentille 21 fait converger le faisceau lumineux vers la photodiode, et permet ainsi l'utilisation d'une photodiode de faible surface.

La figure 5 représente le schéma de principe d'une liaison bidirectionnelle selon l'art connu, comportant une régulation de la puissance lumineuse émise par une DEL. Si on considère l'ensemble émetteur situé à une extrémité d'une fibre optique, il est possible d'améliorer le rendement de la liaison bidirectionnelle en asservissant le rayonnement lumineux émis par la DEL 2 par un système de régulation très simple et bien connu. Une lame semiréfléchissante 6 est placée entre la DEL 2 et la fibre optique 1 et elle réfléchit une partie de la lumière émise par la DEL en direction d'une photodiode 18. Le signal de la photodiode 18 est intégré par un intégrateur 30, qui attaque l'une des deux entrées d'un amplificateur différentiel 31. La sortie de cet amplificateur commande elle-même la base d'un transistor qui assure l'alimentation en courant de la DEL 2. Si, pour des raisons quelconques de dérive en température ou de vieillisement par exemple, la DEL 2 émet une puissance lumineuse qui n'est pas stable, la boucle de contre-réaction permet de corriger et d'obtenir une puissance lumineuse stable.

Ce type de composant optoélectronique comportant une régulation de puissance émise peut être réalisé selon l'invention, telle qu'elle est représentée en figure 6.

Le composant optoélectronique selon l'invention tel qu'il est représenté en figure 6 comporte exactement les mêmes constituants que celui représenté en figure 4. Mais en figure 4 le rayonnement lumineux reçu par la photodiode 5 provient de la fibre optique 12, et par conséquent les deux surfaces réfléchissantes 27 et 28 sont parallèles entre elles, de façon à ce qu'un rayon lumineux issu de la fibre optique parvienne à la photodiode 5. Par opposition, en figure 6 les deux surfaces réfléchissantes 27 et 28 sont montées de façon orthogonale, et une partie du rayonnement lumineux émis par la pastille 2 de la DEL est réfléchi sur le miroir semitransparent 27 puis réfléchi sur la surface réfléchissante 28 et ainsi reçu par la photodiode 5, ce qui permet d'assurer la régulation de la puissance émise par la DEL 2. De même qu'en ce qui concerne la figure 4 les moyens pour maintenir et positionner les deux surfaces réfléchissantes 27 et 28 seront développés ultérieurement.

La figure 7 représente une vue en coupe d'un composant optoélectronique selon l'invention, mais dans une variante de réalisation du système optique.

Selon cette variante, la photodiode 5 reçoit une partie du rayonnement lumineux émis par la DEL 2 au moyen d'une seule surface semiréfléchissante 27, qui est montée sur l'axe optique du système, selon un angle de l'ordre de 30° environ, cet angle étant ajusté en fonction de la position occupée par la photodiode 5 et de son éloignement par rapport à la pastille 2 de la DEL. Ce miroir semitransparent 27 est comme dans les cas des figures 4 et 6 maintenu en place par un support de miroir qui va être maintenant détaillé dans les figures suivantes.

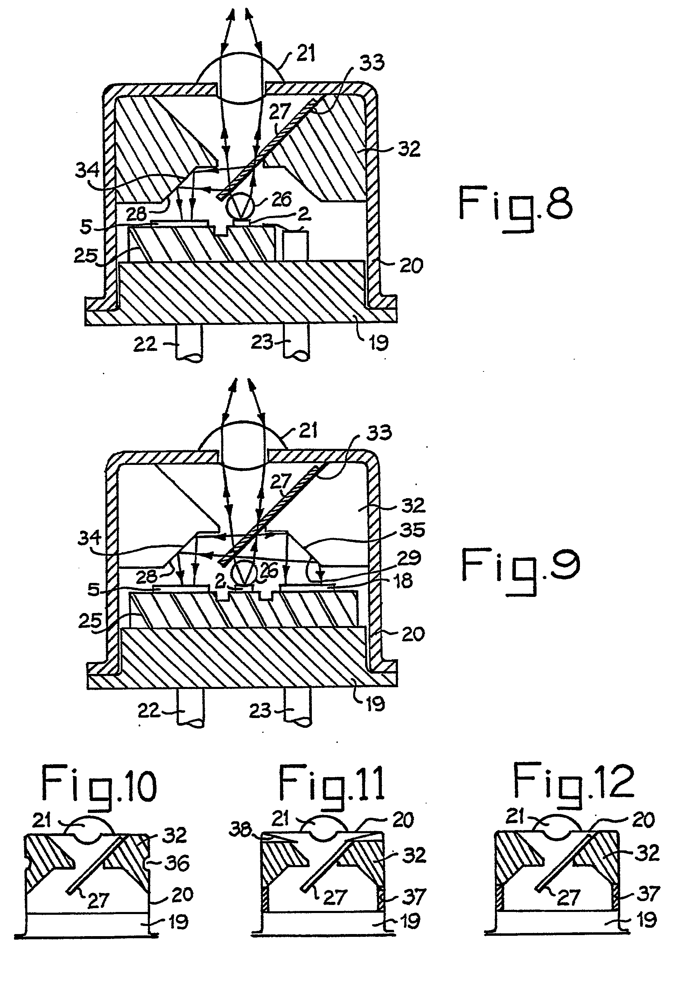

La figure 8 est plus détaillée que la figure 4 : elle représente le même composant optoélectronique pour l'émission et la réception d'un rayonnement lumineux. Elle met en évidence le support de miroir, objet de l'invention, qui permet de transformer facilement une diode électroluminescente en un coupleur d'émission-réception.

A l'intérieur du couvercle 20 d'un boîtier de transistor, muni d'une microlentille 21, est adapté un support de miroir 32, qui a une forme cylindrique puisque les boîtiers de transistors de type TO18 ou TO46 sont cylindriques. A titre de comparaison, la pièce 32 rentre dans le couvercle 20 comme un piston pénètre à l'intérieur d'un cylindre. De façon générale, le contour extérieur du support 32 est adapté au contour intérieur du couvercle 20 du boîtier. La pièce 32, qui à l'origine était donc un cylindre, a subi sur chacune de ces faces planes un fraisage. Sur une face, un fraisage a permis de dégager une surface plane 33, inclinée à 45° par rapport à l'axe optique principal du système, c'est-à-dire également incliné à 45° par rapport à la face plane d'origine de la pièce 32. Sur cette face plane 33 est collé ou fixé par tous moyens convenables le miroir semitransparent 27.

La seconde face plane du support de miroir 32 a subi un second fraisage qui laisse au moins une face plane 34 inclinée à 45° par rapport à l'axe optique du système, c'est-à-dire également inclinée à 45° par rapport à la seconde face plane de la pièce 32. Les deux fraisage se recoupent, en sorte qu'ils créent au centre du support 32 un trou, selon l'axe optique du dispositif, laissant passer les rayons lumineux. De plus, cette surface 34 inclinée à 45° est traitée et polie de façon à constituer une surface réfléchissante de bonne qualité optique. Enfin la première face 33 et la seconde face 34, toutes deux inclinées à 45° par rapport à l'axe optique du système, se font face de telle façon qu'un rayon lumineux provenant de la fibre optique et traversant la microlentille 21 se réfléchisse une première fois sur le miroir 27, collé sur la face 33, puis une seconde fois sur la surface réfléchissante 34, qui constitue ainsi le miroir 28, avant de frapper la photodiode 5.

La figure 9 constitue un cas plus complet de composant optoélectronique selon l'invention, puisque ce composant comporte une DEL d'émission 2, une photodiode de réception 5 et une photodiode de régulation 18 de la puissance émise par la DEL 2.

Dans ce cas les trois pastilles de diodes sont montées côte à côte sur un pavé isolant 25, de la même façon que précédemment deux pastilles de diodes étaient montées sur ce pavé isolant 25. Bien entendu le nombre de connexions extérieures telles que 22 et 23 est adapté au nombre de pastilles de diodes. Le renvoi de la lumière provenant de la fibre optique vers la photodiode 5 s'opère comme précédemment au moyen d'un miroir semitransparent 27 et d'une surface réfléchissante 28. Mais le controle et la régulation de la puissance émise par la DEL 2 au moyen d'une photodiode 18 se fait comme cela a été exposé en figure 6 par le moyen d'une première réflexion sur le miroir semitransparent 27 et d'une seconde réflexion sur le miroir 29 constitué par une partie réfléchissante 35 de la pièce 33 support de miroir. Etant donné la nature plane du miroir semitransparent 27 la réflexion d'un rayon provenant de la DEL 2 en direction de la photodiode 18 et la réflexion d'un rayon lumineux provenant de la fibre optique en direction de la photodiode 5 se font symétriquement : par conséquent les surfaces réfléchissantes 34 et 35 dans la pièce 33 support de miroir se font face à face et leurs génératrices sont parallèles entre elles.

Les figures 10, 11 et 12 représentent de façon très simplifiée les différents moyens pour maintenir en place le support de miroir 33 à l'intérieur du couvercle de boitier 20.

De façon à simplifier ces figures seuls l'embase 19 et le capot 20, le système optique constitué par la microlentille 21 et le miroir 27 ainsi que le support de miroir 33 ont été représentés. Une première façon de fixer le système optique de miroir à l'intérieur d'un capot 20 de boitier de transistor consiste à sertir le support 33 par déformation du capot 36 : ce procédé de sertissage est bien connu, le métal constituant un capot 20 ainsi que le métal constituant le support de miroir 33 sont suffisamment souples pour qu'il soit possible d'y imprimer des déformations telles que 36 avec une pointe métallique.

Un second procédé pour positionner le système optique à l'intérieur du capot 20 de boitier de transistor consiste à maintenir le support de miroir 33 à une distance prédéterminée de l'embase 19 au moyen d'une rondelle 37, et à exercer une force, qui pousse le support 33 en direction de l'embase 19, au moyen d'une rondelle non plane, formant ressort, placée en 38 entre la surface plane du capot 20 et le support de miroir 33.

Enfin une autre possibilité, représentée en figure 12, consiste tout simplement à enfoncer à force la pièce 33 dans le capot 20, ou à la coller dans ce capot et à s'assurer de la distance qui la sépare de l'embase 19 au moyen d'une rondelle 37. Dans les différents cas de figures représentées, le support de miroir 33 est réalisé en métal, fraisé ou matricé, ou bien est injecté en un polymère dont les surfaces 34 et 35 sont rendues réfléchissantes par métallisation sous vide.

Le miroir semitransparent 27 est quand à lui constitué par une fine lame de verre ou de quartz, d'épaisseur de l'ordre 0,1 mm, et selon l'application visée pour le composant optoélectronique, c'est-à-dire selon la longueur d'onde du rayonnement lumineux, le miroir 27 a un coefficient de transmission qui est déterminé par un traitement de surface approprié.

Le composant optoélectronique selon l'invention est principalement utilisé dans les liaisons par fibres optique à haute densité, telle que les liaisons d'échange de données en informatique ou dans les systèmes de téléphonie.

## Revendications

1. Composant optoélectronique bidirectionnel, comportant une diode électroluminescente d'émission et au moins une photodiode (5) de détection, la diode électroluminescente (2), dite DEL, étant montée à l'intérieur d'un boitier métallique de type boitier de transistor, dont l'embase (19) supporte un pavé isolant (25) sur lequel est fixée la DEL (2) et dont le couvercle (20) supporte une microlentille (21), centrée sur la face plane du couvercle (20), la microlentille (21) et la DEL (2) définissant un axe optique pour ce composant optoélectronique, caractérisé en ce que sont intégrés à l'intérieur du boitier (19+20) de la DEL (2):
   – ladite au moins une photodiode (5) de détection, montée sur le pavé isolant (25) à côté de la DEL (2) et en dehors de l'axe optique du composant,
   – un premier moyen de réflexion du rayonnement lumineux, détecté, constitué par un miroir semitransparent (27), supporté entre la DEL (2) et la microlentille (21), sur l'axe optique du composant et incliné par rapport à celui-ci, et
   – un second moyen de réflexion du rayonnement lumineux en direction de la photodiode (5) de détection, constitué par une surface réfléchissante (28), dont le plan est parallèle au plan du miroir semi-transparent (27), la pièce (32) dans laquelle est réalisée la surface réfléchissante (28) comportant également une surface plane (33) support du miroir semi-transparent (27).

2. Composant optoélectronique comportant une diode électroluminescente d'émission (2) et au moins une photodiode (18) de détection, la diode électroluminescente (2), dite DEL, étant montée à l'intérieur d'un boitier métallique de type boitier de transistor, dont l'embase (19) supporte un pavé isolant (25) sur lequel est fixée la DEL (2) et dont le couvercle (20) supporte une microlentille (21), centrée sur la face plane du couvercle (20), la microlentille (21) et la DEL (2) définissant un axe optique pour ce composant optoélectronique, caractérisé en ce que sont intégrés à l'intérieur du boitier (19+20) de la DEL (2):
   – ladite au moins une photodiode (18) de détection, montée sur le pavé isolant (25) à côté de la DEL (2) et en dehors de l'axe optique du composant,
   – un premier moyen de réflexion du rayonnement lumineux détecté, constitué par un miroir semi-transparent (27), supporté entre la DEL (2) et la microlentille (21), sur l'axe optique du composant et incliné par rapport à celui-ci,
   – un second moyen de réflexion du rayonnement lumineux en direction de la photodiode de détection (18), constitué par une surface réfléchissante (29), les deux surfaces réfléchissantes (27, 28) étant disposées de façon orthogonale, la pièce (32) dans laquelle est réalisée la surface réfléchissante (29) comportant également une surface plane (33) support du miroir semi-transparent (27).

3. Composant optoélectronique comportant une diode électroluminescente d'émission et une photodiode (18) de détection, la diode électroluminescente d'émission (2), dite DEL, étant montée à l'intérieur d'un boitier métallique de type boitier de transistor, dont l'embase (19) supporte un pavé isolant (25) sur lequel est fixée la DEL (2) et dont le couvercle (20) supporte une microlentille (21), centrée sur la face plane du couvercle (20), la microlentille (21) et la DEL (2) définissant un axe optique pour ce composant optoélectronique, caractérisé en ce que sont intégrés à l'intérieur du boîtier (19+20) de la DEL (2):
   – la photodiode (18) de détection montée sur le pavé isolant (25) à côté de la DEL (2) et en dehors de l'axe optique du composant, et
   – un moyen de réflexion du rayonnement lumineux détecté, constitué par un miroir semi-transparent (27), placé entre la DEL (2) et la microlentille (21), sur l'axe optique du composant et incliné par rapport à celui-ci, la photodiode (18) recevant une partie du rayonnement lumineux émis par la DEL au moyen de la surface semi-réfléchissante du miroir et le miroir étant maintenu en place par un support disposé à l'intérieur du boîtier.

4. Composant optoélectronique selon la revendication 1, caractérisé en ce qu'il comporte en outre, à l'intérieur du boîtier (19+20), un dispositif de régulation de la puissance lumineuse émise par la DEL (2), ce dispositif comprenant:
   – une seconde photodiode (18) de régulation, montée sur le pavé isolant (25) de l'autre côté de la DEL (2),
   – un second moyen de réflexion (29), qui renvoit vers la seconde photodiode (18), de rayonnement lumineux émis par la DEL (2) qui est partiellement réfléchi sur le miroir semitransparent (27).

5. Composant optoélectronique selon l'une quelconque des revendications 1 à 4, caractérisé en ce que le miroir semitransparent (27) est constitué par une lame de matériau transparent, tel que verre ou quartz, dont les faces sont traitées pour leur communiquer un coefficient de transmission approprié au rayonnement lumineux.

6. Composant optoélectronique selon la revendication 1, caractérisé en ce que le support (32) du miroir semitransparent (27) est constitué par une pièce dont le contour extérieur correspond au contour intérieur du couvercle (20) du boîtier, ce support étant percé en son centre d'un trou selon l'axe optique pour le passage du rayonnement lumineux, et étant muni, du côté en regard de la microlentille (21) d'un plan, incliné par rapport à l'axe optique, et sur lequel est fixé le miroir semitransparent (27), et du côté en regard de la DEL (2) d'au moins un plan (34), dont la surface est polie, formant au moins une surface réfléchissante (28).

7. Composant optoélectronique selon la revendication 6, caractérisé en ce que le support (32) du miroir semitransparent (27) est fixé dans le couvercle (20) du boîtier par emmanchement à force et collage.

8. Composant optoélectronique selon la revendication 6, caractérisé en ce que le support (32) du miroir semitransparent (27) est fixé dans le couvercle (20) du boîtier par déformation localisée (36) du couvercle (20).

9. Composant optoélectronique selon la revendication 6, caractérisé en ce que le support (32) du miroir semitransparent (27) est positionné à l'intérieur du couvercle (20) du boîtier au moyen d'un manchon (37) qui prend appui sur l'embase (19) du boîtier, et maintenu en position au moyen d'une rondelle élastique (38).

10. Composant optoélectronique selon l'une quelconque des revendications 1 à 9, caractérisé en ce qu'il est associé à une fibre optique (12) dans une liaison bidirectionnelle monofibre.

**Claims**

1. A bidirectional opto-electronic component comprising an electroluminescent emission diode and at least one photodetector diode (5), the electroluminescent diode (2), called DEL, being mounted inside a metal casing of the transistor casing type, whose base (19) supports an insulating slab (25), on which the DEL (2) is fixed, and whose cover (20) carries a microlens (21), centered on the plane face of the cover (20), the microlens (21) and the DEL (2) defining an optical axis of the opto-electronic component, characterized in that there are integrated inside the casing (19+20) of the DEL (2):
   – said at least one photodetector diode (5) mounted on the insulating slab (25) aside the DEL (2) and outside the optical axis of the component,
   – a first reflection means for reflecting the detected light radiation, constituted by a semi-transparent mirror (27) supported between the DEL (2) and the microlens (21), on the optical axis of the component and inclined relative to this axis, and
   – a second means for reflecting the light radiation towards the photodetector diode (5) constituted by a reflecting surface (28), whose surface plane is parallel to the plane of the semi-transparent mirror (27) and the member (32) on which the reflecting surface (28) is made comprising also a plane surface (33) for supporting the semi-transparent mirror (27).

2. An opto-electronic component comprising an electroluminescent emission diode (2) and at least one photodetector diode (18), the electroluminescent diode (2), called DEL, being mounted inside a metal casing of the transistor casing type, whose base (19) supports an insulating slab (25), on which the DEL (2) is fixed, and whose cover (20) carries a microlens (21), centered on the plane face of the cover (20), the microlens (21) and the DEL (2) defining an optical axis of the opto-electronic component, characterized in that there are, integrated inside the casing (19+20) of the DEL (2):
   – a first reflection means for reflecting the detected light radiation, constituted by a semi-transparent mirror (27) supported between the DEL (2) and the microlens (21), in the optical axis of the component and inclined relative to this axis, and
   – a second means for reflecting the light radiation towards the photodetector diode (18) constituted by a reflecting surface (29), the two reflecting surfaces (27, 28) being disposed orthogonally to one another and the member (32) on which the reflecting surface (29) is made comprising also a plane surface (33) for supporting the semi-transparent mirror (27).

3. An opto-electronic component comprising an electroluminescent emission diode and a photodetector diode (18), the electroluminescent diode (2), called DEL, being mounted inside a metal casing of the transistor casing type, whose base (19) supports an insulating slab (25), on which the DEL (2) is fixed, and whose cover (20) carries a microlens (21), centered on the plane face of the cover (20), the microlens (21) and the DEL (2) defining an optical axis of the opto-electronic component, characterized in that there are integrated inside the casing (19+20) of the DEL (2):

– the photodetector diode (18) mounted on the insulating slab (25) aside the DEL (2) and outside the optical axis of the component, and
– a first reflection means for reflecting the detected light radiation, constituted by a semi-transparent mirror (27) supported between the DEL (2) and the microlens (21) on the optical axis of the component and inclined relative to this axis, the photodiode (18) receiving a portion of the light radiation emitted by the DEL via the semi-reflecting surface of the mirror, and the mirror being held in place by means of a support disposed inside the casing.

4. An optoelectronic component according to claim 1, characterized in that it includes inside the casing (19+20) a device for adjusting the light power emitted by the DEL (2), the device comprising:

– a second adjusting photodiode (18), mounted on the insulating slab (25) on the other side of the DEL (2),
– a second reflection means (29), which returns the light radiation emitted by the DEL (2) and partially reflected by the semi-transparent mirror (27) towards the second photodiode (18).

5. An opto-electronic component according to any one of claims 1 to 4, characterized in that the semi-transparent mirror (27) is constituted by a dice of transparent material such as glass or quartz, whose faces are worked for having an appropriate transmission coefficient for the light radiation.

6. An opto-electronic component according to claim 1, characterized in that the support (32) of the semi-transparent mirror (27) is constituted by a member whose external contour corresponds to the inner contour of the cover (20) of the casing, this support being pierced at its center by a hole extending along the optical axis for allowing the light radiation to pass, and being provided at the side facing the microlens (21) with a surface which is inclined in relation to the optical axis and on which is fixed the semi-transparent mirror (27), and being provided at the side opposite the DEL (2) with at least one plane (34) whose surface is polished and forms at least one reflecting surface (28).

7. An opto-electronic component according to claim 6, characterized in that the support (32) of the semi-transparent mirror (27) is secured to the cover of the casing by way of forced clamping and gluing.

8. An opto-electronic component according to claim 6, characterized in that the support (32) of the semi-transparent mirror (27) is secured to the cover of the casing by local deformation of the cover (20).

9. An opto-electronic component according to claim 6, characterized in that the support (32) of the semi-transparent mirror (27) is positioned inside the cover (20) of the casing by means of a sleeve (37), which abuts on the base (19) of the casing and is held in place by an elastic washer (38).

10. An opto-electronic component according to any one of claims 1 to 9, characterized in that it is associated with an optical fiber (12) in a bidirectional monofiber link.

**Patentansprüche**

1. Optoelektronisches bidirektionales Bauteil mit einer Elektrolumineszenzemissionsdiode und mindestens einer Photodetektordiode (5), wobei die Elektrolumineszenzdiode (2), DEL genannt, im Inneren eines Metallgehäuses vom Typ eines Transistorgehäuses montiert ist, dessen Grundplatte (19) einen Isolierblock (25) trägt, auf dem die DEL (2) befestigt ist und dessen Deckel (20) mitten auf der ebenen Fläche des Deckels (20) eine Mikrolinse (21) trägt, wobei die Mikrolinse (21) und die DEL (2) für das optoelektronische Bauteil eine optische Achse definieren, dadurch gekennzeichnet, daß im Inneren des Gehäuses (19+20) der DEL (2) zusammengefaßt sind:

– die mindestens eine Photodetektordiode (5), welche auf dem Isolierblock (25) neben der DEL (2) außerhalb der optischen Achse des Bauteils montiert ist,
– ein erstes Mittel zur Reflexion der erfaßten Lichtstrahlung, das aus einem halbtransparenten Spiegel (27) besteht, der zwischen der DEL (2) und der Mikrolinse (21) in der optischen Achse des Bauteils befestigt ist und gegen dieselbe geneigt ist, und
– ein zweites Mittel zur Reflexion des Lichtstrahls in Richtung auf die Photodetektordiode (5), die aus einer reflektierenden Oberfläche (28) besteht, deren Fläche parallel zur Fläche des halbtransparenten Spiegels (27) verläuft, wobei das Element (32), auf dem die reflektierende Oberfläche (28) ausgebildet ist, auch eine ebene Oberfläche (33) besitzt, auf der der halbtransparente Spiegel (27) liegt.

2. Optoelektronisches Bauteil mit einer Elektrolumineszenzemissionsdiode (2) und mindestens einer Photodetektordiode (18), wobei die Elektrolumineszenzdiode (2), DEL genannt, im Inneren eines Metallgehäuses vom Typ eines Transistorgehäuses montiert ist, dessen Grundplatte (19) einen Isolierblock (25) trägt, auf dem die DEL (2) befestigt ist und dessen Deckel (20) mitten auf der ebenen Fläche des Deckels (20) eine Mikrolinse (21) trägt, wobei die Mikrolinse (21) und die DEL (2) für das optoelektronische Bauteil eine optische Achse definieren, dadurch gekennzeichnet, daß im Inneren des Gehäuses (19+20) der DEL (2) zusammengefaßt sind:

– die mindestens eine Photodetektordiode (18), welche auf dem Isolierblock (25) neben der DEL (2) und außerhalb der optischen Achse des Bauteils montiert ist,
– ein erstes Mittel zur Reflexion der erfaßten Lichtstrahlung, das aus einem halbtransparenten Spiegel (27) besteht, der zwischen der DEL (2) und der Mikrolinse (21) in der optischen Achse des Bauteils sitzt und gegen dieselbe geneigt ist,
– ein zweites Mittel zur Reflexion des Lichtstrahls in Richtung auf die Photodetektordiode (18), das aus einer reflektierenden Oberfläche (29) besteht, wobei die beiden reflektierenden Oberflächen (27, 28) orthogonal zueinander angeordnet sind und das Element (32), an dem die reflektierende Oberfläche (29) ausgebildet ist, auch eine ebene Stützoberfläche (33) des halbtransparenten Spiegels (27) aufweist.

3. Optoelektronisches Bauteil mit einer Elektrolumineszenzemissionsdiode (2) und mindestens einer Photodetektordiode (18), wobei die Elektrolumineszenzdiode (2), DEL genannt, im Inneren eines Metallgehäuses vom Typ eines Transistorgehäuses montiert ist, dessen Grundplatte (19) einen Isolierblock (25) trägt, auf dem die DEL (2) befestigt ist und dessen Deckel (20) mitten auf der ebenen Fläche des Deckels (20) eine Mikrolinse (21) trägt, wobei die Mikrolinse (21) und die DEL (2) für das optoelektronische Bauteil eine optische Achse definieren, dadurch gekennzeichnet, daß im Inneren des Gehäuses (19+20) der DEL (2) zusammengefaßt sind:
– die Photodetektordiode (18), welche neben der DEL (2) außerhalb der optischen Achse des Bauteils montiert ist, und
– ein erstes Mittel zur Reflexion der erfaßten Lichtstrahlung, das aus einem halbtransparenten Spiegel (27) besteht, der zwischen der DEL (2) und der Mikrolinse (21) in der optischen Achse des Bauteils angebracht und gegen dieselbe geneigt ist, wobei die Photodiode (18) einen Teil der von der DEL über die halbreflektierende Oberfläche des Spiegels ausgesandten Lichtstrahlung empfängt und der Spiegel mit Hilfe eines im Inneren des Gehäuses angebrachten Halters arretiert sind.

4. Optoelektronisches Bauteil nach Anspruch 1, dadurch gekennzeichnet, daß es weiter im Inneren des Gehäuses (19+20) eine Vorrichtung zum Einstellen der von der DEL (2) emittierten Leuchtstärker enthält, die aufweist:
– eine zweite Einstellphotodiode (18), die auf einem Isolierblock (25) gegenüber der DEL (2) montiert ist,
– ein zweites Reflexionsmittel (29), welches die von der DEL (2) emittierte Lichtstrahlung, die teilweise auf den halbtransparenten Spiegel (27) reflektiert wird, auf die zweite Photodiode (18) wirft.

5. Optoelektronisches Bauteil nach einem beliebigen der Ansprüche 1 bis 4, dadurch gekennzeichnet, daß der halbtransparente Spiegel (27) aus einer Scheibe durchscheinenden Materials wie Glas oder Quarz besteht, deren Flächen so behandelt sind, daß sie einen geeigneten Durchlaßkoeffizienten für die Lichtstrahlung besitzen.

6. Optoelektronisches Bauteil nach Anspruch 1, dadurch gekennzeichnet, daß das Tragelement (32) des halbtransparenten Spiegels (27) aus einem Element besteht, dessen äußere Kontur der inneren Kontur des Deckels (20) des Gehäuses entspricht, wobei das Tragelement mittig mit einem Loch in der optischen Achse für den Durchtritt der Lichtstrahlung versehen ist und weiter auf der Seite gegenüber der Mikrolinse (21) eine gegen die optische Achse geneigte Fläche, auf der der halbtransparente Spiegel (27) befestigt ist, sowie auf der Seite gegenüber der DEL (2) mindestens eine Fläche (34) besitzt, deren Oberfläche poliert ist und die mindestens eine reflektierende Oberfläche (28) aufweist.

7. Optoelektronisches Bauteil nach Anspruch 6, dadurch gekennzeichnet, daß das Tragelement (32) des halbtransparenten Spiegels (27) am Deckel (20) des Gehäuses durch Einpressen und Kleben befestigt ist.

8. Optoelektronisches Bauteil nach Anspruch 6, dadurch gekennzeichnet, daß das Tragelement (32) des halbtransparenten Spiegels (27) am Deckel (20) des Gehäuses durch örtliche Verformung (36) des Deckels (20) befestigt ist.

9. Optoelektronisches Bauteil nach Anspruch 6, dadurch gekennzeichnet, daß das Tragelement (32) des halbtransparenten Spiegels (27) im Deckel (20) des Gehäuses mit Hilfe einer Manschette (37) positioniert ist, die auf der Grundplatte (19) des Gehäuses aufsitzt und durch eine elastische Unterlegscheibe (38) in Stellung gehalten wird.

10. Optoelektronisches Bauteil nach einem der Ansprüche 1 bis 9, dadurch gekennzeichnet, daß es einer optischen Faser (12) in einer bidirektionalen Monofaserverbindung zugeordnet ist.

Fig.1

Fig.2

Fig.3

Fig.5

Fig.4

Fig.6

Fig.7

**Fig.8**

**Fig.9**

**Fig.10**

**Fig.11**

**Fig.12**